# EUROPEAN PATENT APPLICATION

(11) **EP 3 451 489 A1**
(43) Date of publication of application: **06.03.2019**
(21) Application number: 18191864.0
(22) Date of filing: 30.08.2018
(51) Int. Cl.: H02J 9/06

(54) **RACK MOUNT UPS DOCK WITH BYPASS CAPABILITY**

(30) Priority: 31.08.2017 US 201715692248
(71) Applicant: Schneider Electric IT Corporation, West Kingston, RI 02892 (US)
(72) Inventor: NOMMENSEN, Carsten, West Kingston, RI 02892 (US); SILBERBAUER, Kristian, West Kingston, RI 02892 (US); STOEVRING, Morten, West Kingston, RI 02892 (US)
(74) Representative: Murgitroyd & Company

(57) **Abstract**

An uninterruptible power supply (UPS) system includes a UPS unit having one or more power connectors and control signal connectors. The UPS system further includes a frame configured to removably engage and receive the UPS unit, and a bypass unit positioned within the frame and coupled to a power input and output. The bypass unit has corresponding power and control signal connectors configured to mate with respective UPS power and control signal connectors responsive to the positioning of the UPS within the frame. The bypass unit further includes a bypass switch controllable between open and closed states, which may be a normally closed relay. When the bypass switch is closed, the bypass branch shunts power around the UPS without decoupling the input from the output. A controller positioned within or outside the UPS controls the bypass switch via one or more control signal lines.

## Description

### TECHNICAL FIELD

Aspects and implementations of the present disclosure are directed generally to uninterruptible power supplies.

### BACKGROUND

Critical power loads are often protected by a plurality of uninterruptible power supplies (UPS) working together such that each UPS provides a stable source of backup power to all or part of the critical loads. Groups of UPS devices are often mounted within a rack with multiple racks being arranged side-by-side into rows, for example, in a data center. Each rack-mounted UPS is coupled to an external source of power, such as utility power, and is further coupled to a load. In a normal mode of operation, the UPS provides utility power to the load. In the event of a power interruption or other power-related event, the UPS enters a backup mode of operation and draws upon power stored in one or more batteries to provide power to the load.

### SUMMARY

In accordance with an aspect of the present disclosure, there is provided an uninterruptible power supply (UPS) system including a UPS unit having a first UPS connector and a second UPS connector; a frame configured to removably engage and receive the UPS unit; and a bypass unit disposed within the frame. The bypass unit includes an input to receive input power; an output to provide output power; a bypass branch configured to selectively couple the input to the output. The bypass branch includes a bypass switch configured to switch between an open state and a closed state, such that in the open state the bypass switch is configured to prevent current through the bypass branch, and in the closed state the bypass switch is configured to allow current through the bypass branch. The bypass unit further includes a first power connector disposed on the bypass unit, the first power connector being coupled to the input and configured to couple to the first UPS connector responsive to the UPS unit being received by the frame; and a second power connector disposed on the bypass unit, the second power connector being coupled to the power output and configured to electrically couple to the second UPS connector responsive to the UPS unit being received by the frame.

In various embodiments the UPS system is further configured such that the first and second power connectors and the first and second UPS connectors couple the bypass unit to the UPS unit responsive to the UPS unit being inserted into the frame beyond a first position of the frame located between a front portion of the frame and the bypass unit.

The UPS system may also include a bypass control signal connector disposed on the bypass unit, the bypass control signal connector configured to electrically couple to the UPS unit responsive to the UPS unit being received by the frame. The bypass control signal connector may be configured to electrically couple to the UPS unit responsive to the UPS unit being inserted into the frame beyond a second position of the frame located closer to the bypass unit than the first position. The bypass switch may further be configured to receive a first bypass signal from the UPS unit through the bypass control signal connector, the first bypass signal being configured to switch the bypass switch from the closed state to the open state.

In certain embodiments the bypass switch also includes a normally closed relay. The bypass switch may also be configured to receive a second bypass signal from a controller disposed within the frame, the second bypass signal being configured to control the bypass switch to the closed state. The UPS may also be configured to transmit the first bypass signal responsive to determining that the UPS is operating in satisfactory condition.

In certain additional embodiments, the bypass switch is configured to switch to the closed position responsive to the UPS being removed from the frame past the second position. Further, the UPS may be configured to operate in a static bypass mode responsive to the UPS being removed from the frame past the second position. The frame may also include mounting brackets configured to allow the frame to be installed within a position in an equipment rack.

According to another aspect of the present disclosure, there is provided a method for controlling power to a UPS system having a frame configured to receive a UPS and a bypass unit positioned within the frame, the bypass unit including a first input to receive input power from a power source, a first output to provide output power to a load, a second output to provide power to the UPS, a second input to receive power from the UPS, and a bypass branch having a bypass switch coupled between the first input and the first output. The method involves controlling the bypass switch to switch from an open state to a closed state responsive to the UPS being disengaged from the bypass unit and removed from the frame, the open state being configured to prevent current through the bypass branch and the closed state being configured to allow current through the bypass branch to allow the bypass unit to operate in a bypass mode of operation; and controlling the bypass switch to switch from the closed state to the open state responsive to the UPS being received by the frame and engaged with the bypass unit.

In various additional embodiments, the method further involves controlling the bypass switch to switch from the open state to the closed state responsive to the UPS being removed from the frame is further responsive to the UPS being removed from the frame beyond a first position in the frame between a front portion of the frame and the bypass unit. The method may also include controlling the bypass switch from the closed state to the open state responsive to the UPS being received by the frame is further responsive to the UPS being inserted into the frame beyond the first position. In addition, the method may include controlling the UPS to enter a static bypass mode responsive to the UPS being inserted into the frame beyond the first position.

In certain embodiments, the method also includes determining whether the UPS is operating in a satisfactory condition; and disabling the static bypass mode responsive to determining that the UPS is operating in the satisfactory condition. The method may also involve the bypass switch including a normally closed relay and controlling a state of the relay using a control signal generated by the UPS. Further, the method may involve the UPS remaining electrically coupled to the second input and the second output until being removed from the frame beyond a second position in the frame, the second position being further from the bypass unit than the first position.

According to an additional aspect of the present disclosure, there is provided a UPS system including an input to receive input power; an output to provide output power to a load; a UPS unit having a first UPS connector to couple to the input and a second UPS connector to couple to the output; a frame configured to removably engage and receive the UPS unit; and means for detecting removal of the UPS unit from the frame and in response coupling the input to the output to power the load with the UPS unit removed from the frame. The UPS system may further include means for detecting insertion of the UPS unit into the frame and in response decoupling the input from the output.

### BRIEF DESCRIPTION OF THE DRAWINGS

Various aspects of at least one example are discussed below with reference to the accompanying figures, which are not intended to be drawn to scale. The figures are included to provide illustration and a further understanding of the various aspects and examples, and are incorporated in and constitute a part of this specification, but are not intended as a definition of the limits of the disclosure. In the figures, each identical or nearly identical component that is illustrated in various figures is represented by a like numeral. For purposes of clarity, not every component may be labeled in every figure. In the figures:
FIG. 1 is block diagram showing a UPS according to various aspects and embodiments of this disclosure;
FIG. 2A is a rear perspective diagram of a rack-mountable UPS System that includes the UPS of FIG. 1 mounted in a mounting frame, with the UPS fully engaged with the mounting frame;
FIG. 2B is a rear perspective diagram showing the rack-mountable UPS system of FIG 2A with the UPS partially disengaged from the mounting frame;
FIG. 3A is front perspective diagram showing the rack-mountable UPS system of FIG 2A with the UPS fully engaged with the mounting frame;
FIG. 3B is a front perspective diagram showing the rack-mountable UPS system of FIG 2A with the UPS partially disengaged from the mounting frame;
FIG. 4 is an overhead plan view showing the rack-mountable UPS system of FIG 2A with the UPS fully engaged with the mounting frame;
FIG. 5 is an overhead plan view showing the rack-mountable UPS system of FIG 2A with the UPS partially disengaged from the mounting frame;
FIG. 6 is an overhead plan view showing a portion of the rack-mountable UPS system of FIG. 4;
FIG. 7 is an overhead plan view showing a portion of the rack-mountable UPS system of FIG. 5;
FIG. 8 is a diagram showing an embodiment of a rack system including a rack for housing one or more rack-mountable UPS systems, such as the rack-mountable UPS system shown in FIG. 2A;
FIG. 9 is a flowchart showing an embodiment of a method for removing a UPS from a rack and automatically enabling a maintenance bypass unit, such as the UPS and maintenance bypass unit of the UPS system shown in FIG. 2A;
FIG. 10 is a flowchart showing another embodiment of a method for removing a UPS from a rack and automatically enabling a maintenance bypass unit, such as the UPS and maintenance bypass unit of the UPS system shown in FIG. 2A; and
FIG. 11 is a flowchart showing an embodiment of a method for inserting a UPS into a rack and automatically disabling a maintenance bypass unit, such as the UPS and maintenance bypass unit of the UPS system shown in FIG. 2A.

### DETAILED DESCRIPTION

When a rack-mounted uninterruptible power supply (UPS) requires maintenance or needs replacement, it is typically first disabled and then removed from its position within the rack. A maintenance technician will often need to access a rear portion of the rack to manually engage a maintenance bypass unit before removing the UPS from the rack. Navigating between rows of racks to access a rear portion can be difficult due to the number of racks typically installed in a row of a data center. The need to manually engage a maintenance bypass unit is also prone to human error and can result in unintentional and harmful load drops. Accordingly, a need exists for configuring rack-mountable UPS devices to automatically enter a maintenance bypass mode that does not require a user to manually engage a bypass unit or access the rear portion of the rack.

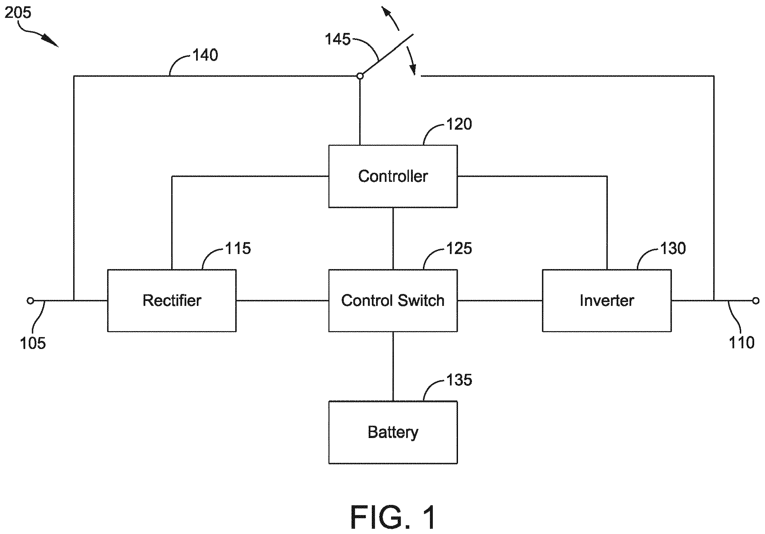

FIG. 1 is a block diagram of an UPS 205 according to various aspects and embodiments of this disclosure. The UPS 205 includes a power input 105 for receiving power, such as AC power generated by a utility. The UPS 205 further includes a controller 120 configured to control a rectifier 115, a control switch 125, an inverter 130, a static bypass switch 145, and other components of the UPS 205.

When in a normal mode of operation, the controller 120 controls the control switch 125 to electrically couple the rectifier 115 to the input 105, electrically couple the inverter 130 to the rectifier 115, and electrically couple the inverter 130 to the output 110 such that power is provided to the output 110 via the input 105. The controller 120 may further control the control switch 125 to couple the battery 135 to the rectifier 115 so that the input 105 provides power to both the battery 135 (so as to charge the battery) and the output 110 while the UPS 205 is operating in the normal mode. In at least some embodiments, in the normal mode of operation, power at the output may also be derived from the battery to meet high peak power demand needs.

When in a backup mode of operation, the controller 120 controls the control switch 125 to electrically couple the battery 135 to the inverter 130 and electrically couple the inverter 130 to the output 110 such that power is provided to the output 110 via the battery 135. The controller may further control the rectifier 115 to decouple from the input 105.

When in a static bypass mode of operation, the controller 120 controls the static bypass switch 145 to provide input power at the output 110, bypassing both the rectifier 115 and the inverter 130 via a static bypass branch 140. In some embodiments, power may still be provided from the input 105 to the battery 135 via the rectifier 115 (so as to charge the battery 135 and provide power for the controller 120) while the UPS 205 is operating in the static bypass mode.

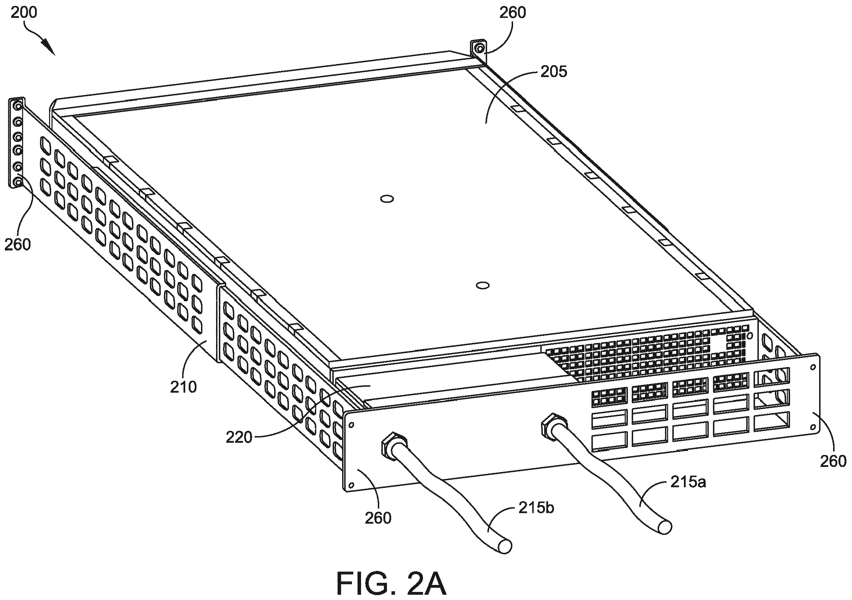

FIG. 2A is a rear perspective view showing a rack-mountable UPS system 200 including the UPS 205 shown in FIG. 1, configured to removably engage a mounting frame 210. A maintenance bypass unit 220 is disposed within the frame 210 in a rear portion 255 of the frame 210 as shown in FIG. 2A. In various embodiments, the maintenance bypass unit 220 is secured to the rear portion 255 of the frame 210 using one or more fastening technologies known to those in the art including screws, rivets, bolts, welding, etc. The maintenance bypass unit 220 is electrically coupled to a power input 215a and a power output 215b. In FIG. 2A, the UPS 205 is fully inserted into the frame 210 in a fully engaged position with the maintenance bypass unit 220.

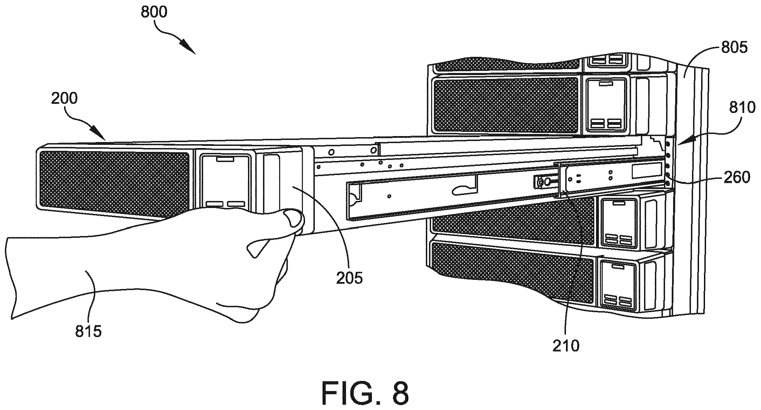

The mounting frame 210 further includes mounting brackets 260 configured for mounting the frame 210 to a location within a rack. Specifically, the mounting brackets 260 allow the frame 210 to be mounted at a position or slot 810 within a rack 805, as shown in FIG. 8. As shown in FIGS. 2A-3B, mounting brackets 260 are disposed at each corner of the frame 210 and each bracket includes one or more screw holes for fastening the frame 210 via the brackets. Those having skill in the art will appreciate that other known mechanisms for mounting a frame to an external structure such as a rack may be used instead.

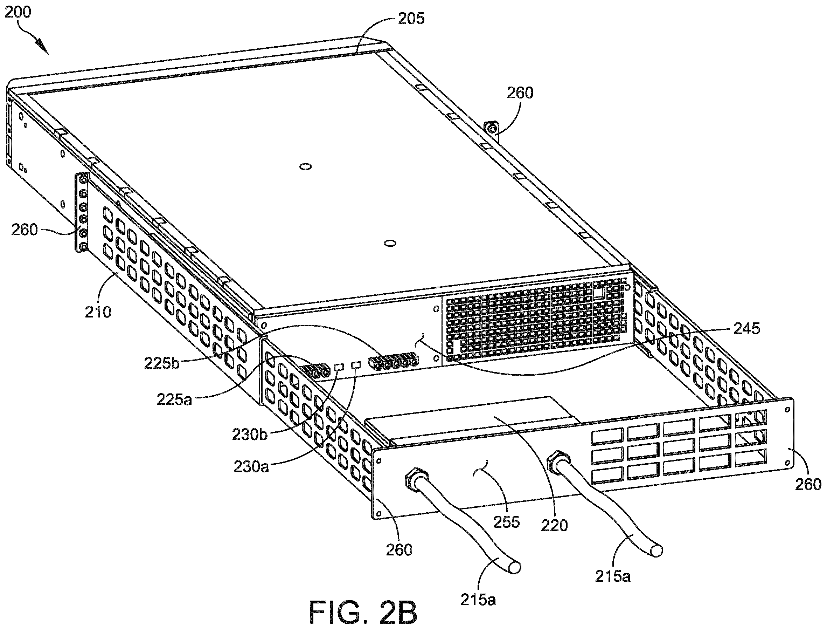

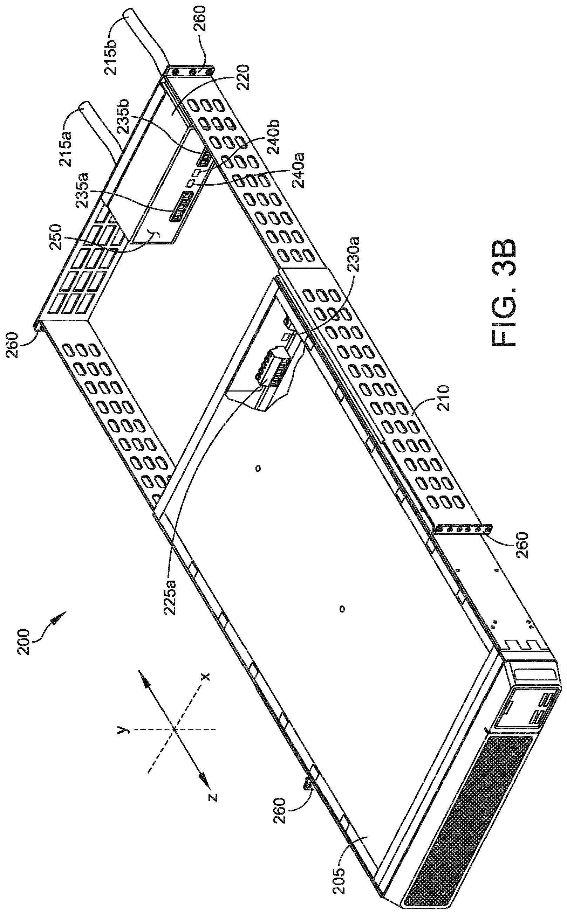

FIG. 2B is a rear perspective view showing the rack-mountable UPS system 200 with the UPS 205 partially removed from the frame 210 and disengaged from the maintenance bypass unit 220. A plurality of blind mate connectors 225a, 225b, 230a, and 230b are disposed on an exterior rear surface 245 of the UPS 205. When the UPS 205 is fully inserted in the frame 210 and engaged with the maintenance bypass unit 220, the blind mate connectors 225a, 225b, 230a and 230b mate with corresponding connectors on the maintenance bypass unit shown below in FIG. 3B.

The UPS 205 includes two blind mate connectors for transferring power: power connector 225a for receiving input power and power connector 225b for providing output power. The blind mate connector 225a is electrically coupled to the UPS power input 105 and the blind mate connector 225b is electrically coupled to the UPS power output 110. Blind mate connectors 230a and 230b are used for carrying control signals between the UPS 205 and the bypass maintenance unit 220. The blind mate connectors 230a and 230b couple to the UPS controller 120 and in one embodiment are configured to provide an indication of whether the UPS 205 is fully inserted in the frame 210 and engaged with the maintenance bypass unit 220.

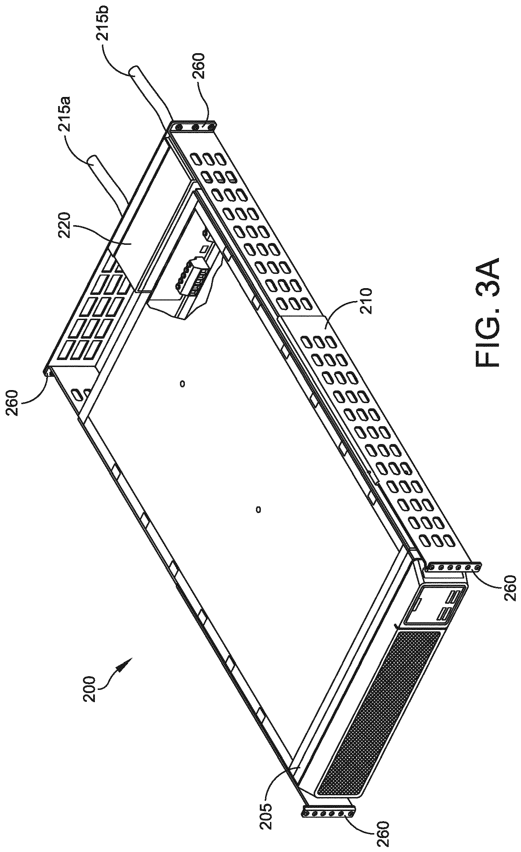

FIG. 3A is a front perspective view showing the rack-mountable UPS system 200 including the UPS 205 in a fully engaged position with the frame 210. The external rear surface 245 (as shown in FIG. 2B) of the UPS 205 abuts an external front surface 250 (as shown in FIG. 3B) of the maintenance bypass unit 220 disposed within the frame 210.

FIG. 3B is a partial-cutaway diagram showing a front perspective view of the rack-mountable UPS system 200 including the UPS 205 in a disengaged position from the maintenance bypass unit 220 and partially removed from the frame 210. The maintenance bypass unit 220 includes blind mate connectors 235a, 235b, 240a and 240b.

The blind mate connectors 235a and 235b are power connectors and are each configured to mate with corresponding UPS power connectors 225a and 225b when the UPS 205 is inserted beyond a first position to engage the maintenance bypass unit 220. The blind mate connectors 240a and 240b are control signal connectors and are each configured to mate with corresponding UPS control signal connectors 230a and 230b when the UPS 205 is inserted beyond a second position to engage the maintenance bypass unit 220.

The blind mate connectors 225a, 225b, 230a, 230b located on the UPS are aligned such that when the UPS 205 is sufficiently inserted into the frame 210, as discussed above, the blind mate connectors 225a, 225b, 230a, and 230b located on the UPS mate with and become electrically coupled to corresponding blind mate connectors 235a, 235b, 240a, and 240b located on the maintenance bypass unit. Proper alignment between the blind mate connectors 225a, 225b, 230a, 230b (located on the UPS) and the blind mate connectors 235a, 235b, 240a, 240b (located on the bypass unit) is achievable due to the fact that the UPS 205 engages with the frame 210 along a fixed path or axis as the UPS 205 is inserted into the frame.

Specifically, the UPS 205 is inserted along a z-direction of a three-dimensional Cartesian coordinate system shown in FIG. 3B for reference. As the UPS 205 is inserted into the frame 210, the frame 210 guides the UPS 205 such that the UPS 205 may only move back-and-forth in the z-direction relative to the frame 210. The positioning of each blind mate connector on the UPS 205 is aligned both in the x-direction and the y-direction relative to each corresponding blind mate connector on the bypass unit 220. This alignment ensures that when the UPS 205 is sufficiently inserted into the frame 210, the corresponding pairs of blind-mate connectors mate with one and other without needing to be manually aligned or otherwise adjusted in either the x-direction or the y-direction.

Still referring to FIG. 3B, when the UPS is fully inserted into the frame 210 (as shown in FIGS. 2A and 3A), the blind mate connectors 225a, 225b, 230a, and 230b on the UPS contact and mate with their respective counterpart blind mate connectors 235a, 235b, 240a, and 240b located on the maintenance bypass unit. The blind mate connectors 225a, 225b, 235a, and 235b (power connectors) each include one or more pins or sockets configured to mate with the corresponding pins or sockets on its counterpart and achieve a certain amount of surface overlap in the z-direction. The pins and sockets located within the power connectors 225a, 225b, 235a, and 235b are each configured to achieve a first amount of surface overlap in the z-direction when fully engaged, for example an overlap between 0.01 mm and 50 mm. The blind mate connectors 230a, 230b, 240a, and 240b (control signal connectors) may similarly include one or more pins or sockets configured to mate with one another as the UPS 205 is inserted into the frame in the z-direction. Pins and sockets located within the control signal connectors may be configured to achieve a second amount of surface overlap in the z-direction when fully engaged, for example an overlap between 0.005 mm and 25 mm, the second amount being less than the first amount.

In some embodiments, one or more of the control signal connectors may not include pins and sockets configured to mate and overlap in the z-direction. For example, a rear-facing surface of the control signal connectors 230a and/or 230b oriented parallel to the xy-plane may be configured to engage and abut a front-facing surface of the corresponding control signal connectors 240a and/or 240b similarly oriented parallel to the xy-plane. Accordingly, the two surfaces will contact each other when the UPS 205 is sufficiently inserted into the frame 210 without overlapping in the z-direction. However, sufficient electrical contact for passing certain control signals can still be established via the contact occurring between the two surfaces in the x-direction and the y-direction, without any overlap in the z-direction. Alternatively, the control signal connectors 230a, 230b, 240a, 240b, and any pins, sockets, or surfaces therein, may comprise a different type of signal connection mechanism known to those in the art such as an optical connector, proximity sensor, etc. In certain embodiments, the control signal connectors may be able to pass control signals to one another when fully engaged without requiring physical contact, for example when using certain types of proximity, optical, or other types of non-contact sensors. In certain embodiments, one or more sets of the power connectors 225a, 225b, 235a, and 235b may also comprise an alternate type of signal connector capable of wired or wireless power coupling, such as inductive, capacitive, or optical power coupling.

Since the control signal connectors 230, 240 have lesser (or zero) amount of overlap or contact in the z-direction relative to the power connectors 225, 235 when the UPS 205 is fully engaged, as the UPS 205 is removed from the frame 210, contact between the control signal connectors will break before a break in contact occurs between the power connectors. This arrangement allows for control circuitry coupled to the control signal connectors to receive an indication that the UPS 205 is being removed from the frame 210 prior to electrical contact being broken between the power connectors. Accordingly, action may be taken to ensure that the bypass system 200 is operating in the correct mode after contact has been broken between the control signal connectors, but before contact is broken between the power connectors.

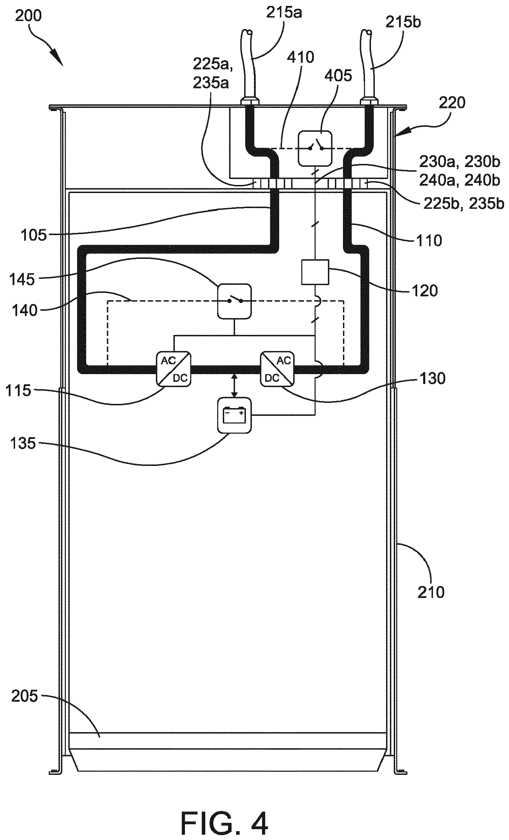

FIG. 4 is an overhead plan view showing a functional block diagram of the connectivity of the UPS system 200 with the UPS 205 fully inserted into the frame 210 and in an engaged position with the maintenance bypass unit 220. The rear external surface of the UPS 205 abuts the front external surface of the maintenance bypass unit 220 located at the rear of the frame 210. The UPS blind mate power connectors 225a and 225b are coupled to the respective bypass unit power connectors 235a and 235b. The blind mate connector 235a is further coupled to the power input line 215a for receiving input power entering the system 200. The blind mate connector 235b is further coupled to power output line 215b for providing output power leaving the system 200. Similarly, the UPS blind mate control signal connectors 230a and 230b are coupled to the respective bypass unit control signal connectors 240a and 240b. The maintenance bypass unit 220 includes a maintenance bypass branch 410 coupled to the power input line 215a and the power output line 215b. The maintenance bypass branch 410 includes a maintenance bypass switch 405 disposed along the bypass branch 410. As shown in FIG. 4, the maintenance bypass switch 405 is open, which prevents any power through the maintenance bypass line 410.

The input power line 215a transfers power through power connectors 225a, 235a and into the UPS power input 105 when the maintenance bypass switch 405 is open. As shown in FIG. 4, when the UPS 205 is operating in the normal mode, power passes in through the input 105, through the rectifier 115, through the inverter 130, and out through the UPS power output 110. Power connectors 225b, 235b receive power from the UPS power output 110 and transfer the power to the power output line 215b. When the UPS 205 is not receiving enough input power via power input 105, the UPS 205 enters the backup mode, which, as discussed above, involves the controller 120 coupling the battery 135 to the inverter 130 and allowing the battery 135 to provide power to the inverter 130.

In at least some embodiments, the UPS 205 may operate in the static bypass mode discussed above. While operating in the static bypass mode, the controller 120 closes the static bypass switch 145 causing input power to bypass the inverter 130 via the static bypass branch 140 and providing power to the output 110 (also via the static bypass branch 140). When operating in the static bypass mode, some power may still be provided to the battery 135 via the rectifier 115, but remaining power entering the input 105 will be provided to the output 110 via the static bypass branch 140, not via the inverter 130.

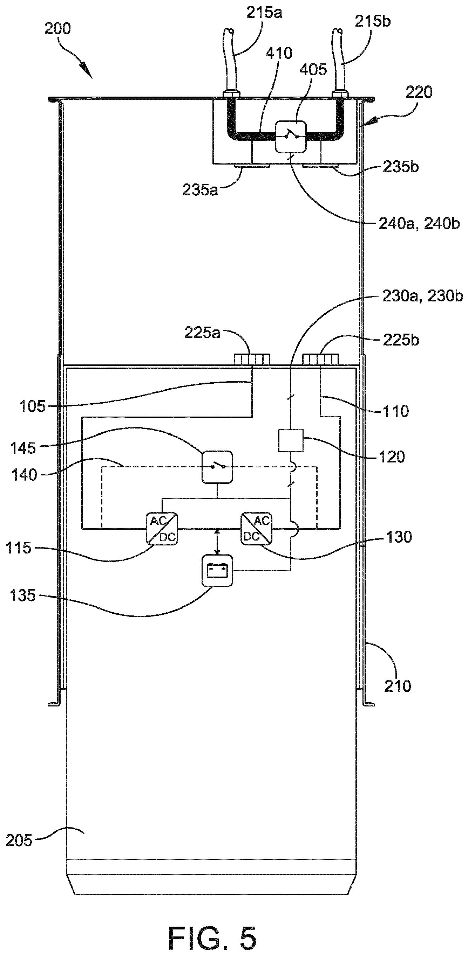

FIG. 5 is an overhead plan view showing a functional block diagram of the connectivity of the UPS system 200 with the UPS 205 partially removed from the frame 210 and disengaged from the maintenance bypass unit 220. The UPS power connectors 225a and 225b are disconnected from the corresponding bypass unit power connectors 235a and 235b such that power is not provided to the UPS 205 though the UPS power input 105 or UPS power output 110. The UPS control signal connectors 230a, 230b are similarly disconnected from the corresponding bypass unit control signal connectors 240a, 240b such that the maintenance bypass switch 405 is closed. The maintenance bypass switch 405 includes a switching element such as a relay, transistor, or other types of switches, and may further include additional control circuitry to control operation of the switching element (not shown). In the example shown in FIG. 5, the maintenance bypass switch 405 is closed causing power entering the power input line 215a to pass through the maintenance bypass branch 410 and exit through the power output line 215b.

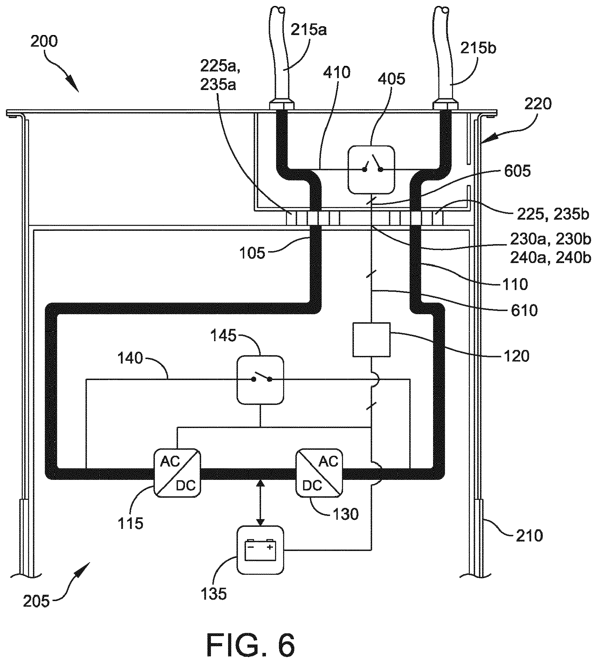

FIG. 6 is an overhead plan view showing a functional block diagram with a close-up view of the UPS system 200 shown in FIG. 4. As discussed with respect to FIG. 4, the UPS control signal connectors 230a and 230b are connected to the bypass control signal connectors 240a and 240b. The UPS controller 120 provides control signals along one or more control lines or buses 610 coupled to each UPS control signal connector 230a and 230b. The control signals travel through to each bypass control signal connector 240a and 240b via the connection to each respective UPS control signal connector 230a and 230b. The control signals then travel along one or more additional control lines or buses 605 coupled to each bypass control signal connector 240a and 240b. The control signals are provided to the maintenance bypass switch 405 or associated control circuitry (not shown) via the additional control lines or buses 605 to control the state of the bypass switch 405.

The control signals control the position of the maintenance bypass switch 405. In the example shown in FIG. 6, the maintenance bypass switch 405 is receiving an open signal from the controller 120, causing the maintenance bypass switch 405 to remain open and allowing power to enter and exit the UPS 205 via the power input 105 and power output 110, respectively.

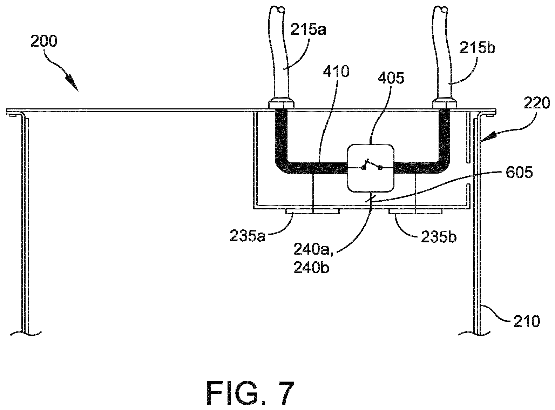

FIG. 7 is an overhead plan view showing a functional block diagram with a close-up view of the bypass unit 220 shown in FIG. 5. The bypass control signal connectors 240a and 240b are shown disconnected from the corresponding UPS control signal connectors 230a and 230b, cutting off any signals on the control lines 605. The maintenance bypass switch 405 may, for example, be configured to be normally closed (close in response to a lack of signals on the control line 605) thereby allowing power to enter the power input line 215a and be provided through the maintenance control branch 410 and out of the power output line 215b. In one embodiment, the bypass switch 405 may include a normally closed relay operable to maintain power through the bypass line absent a signal from the UPS 205.

The system 200 is designed such that when a UPS 205 is removed from the frame 210, power passes through the maintenance bypass branch 405 instead of through the UPS 205. Accordingly, any loads coupled to the output line 215b will continue to receive power when the UPS 205 is removed without the need for manual activation of the maintenance bypass switch.

FIG. 8 is a diagram showing an embodiment of a rack system 800 including a rack 805 for housing one or more of the rack-mountable UPS systems 200 described herein. Each UPS unit 205 is configured to dock within its corresponding frame 210 occupying a slot 810 within the rack 805. A user 815 is shown accessing the front of the rack 805 and manually removing a UPS unit 205 from its slot 810 within the rack 805 by pulling on a front portion of the UPS 200 such that the UPS 200 slides out of its frame 210.

Although not shown in FIG. 8, as the UPS 205 slides out of its slot 810, the blind mate connectors 225a, 225b, 230a, and 230b located on the rear portion of the UPS 205 disengage from corresponding blind mate connectors 235a, 235b, 240a, and/or 240b, located on the front portion of the maintenance bypass unit 220 (as shown in FIGS. 2A-3B). As discussed above, when the blind mate control signal connectors 230a, 230b, 240a, 240b are sufficiently disengaged, the maintenance bypass switch 405 is closed allowing power through the maintenance bypass line 410 to bypass the UPS 205 completely. A user 815 or mechanical arm (not shown) is therefore able to remove and insert the UPS 205 by accessing a front portion of the rack 805 without having to access a rear portion of the rack 805.

The mounting brackets 260 disposed on each corner of the frame 210 include a number of screw holes. Although not shown, each rack 805 includes corresponding holes disposed at locations where the frame 210 is intended to be mounted and aligned with the screw holes on the brackets. Accordingly, the frame 210 may be mounted to the rack 805 via the mounting brackets 260 by placing screws or other fastening mechanisms through the respective holes on the frame 210 and rack 805 such that each bracket is attached to the frame 210. Those having skill in the art will appreciate that other mechanisms for mounting or fastening the frame 210 to a certain slot 810 in the rack 805 may be used instead without disrupting the functionality of the present invention.

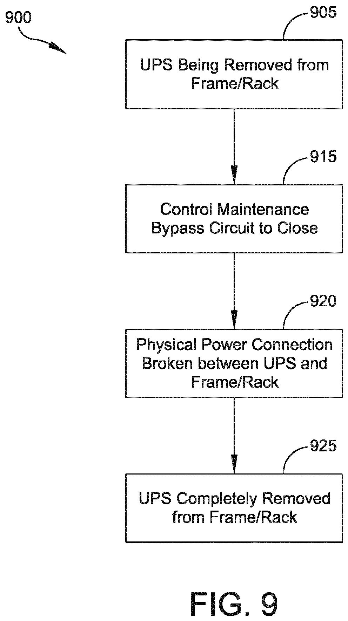

FIG. 9 is a flowchart showing one embodiment of a method 900 of removing the UPS 205 from its slot 810 within the rack 800 including the rack-mountable UPS system 200 of the present disclosure. At act 905, a user 815 begins removing the UPS unit 205 from the frame 210. At act 915, one or more pairs of control signal connectors 230a, 240a become disconnected causing the maintenance bypass 405 switch to close in response. In embodiments where the bypass switch 405 is normally closed, the UPS 205 provides the bypass switch 405 with a continuous or periodic signal to remain open via the control signal line 605. During act 915, when the UPS 205 is sufficiently removed from the frame 210 causing contact between the control signal connectors to break, the signal no longer reaches the bypass switch 405 via signal line 605. Accordingly, the bypass switch 405 will assume its normally closed position responsive to no longer receiving the signal.

In various other embodiments, the bypass switch 405 may instead be configured to open or close responsive to different types of signals. For example, the bypass switch 405 may be configured to be normally open and only close responsive to receiving a signal to close from external control circuitry (not shown). Such external control circuitry may be configured to detect removal of the UPS 205 beyond a certain position and responsively cause the bypass switch 405 to close. The external control circuitry may be located inside the bypass unit 220, or at another location within the frame 210 or rack 805. The bypass switch 405 may also be configured to require specific signals for entering either of the open and closed positions, and assume an indeterminate or other fixed state by default in response to no signal. For example, external control circuitry as described above may be configured to send a specific signal for controlling the bypass switch 405 into each of the open and closed positions.

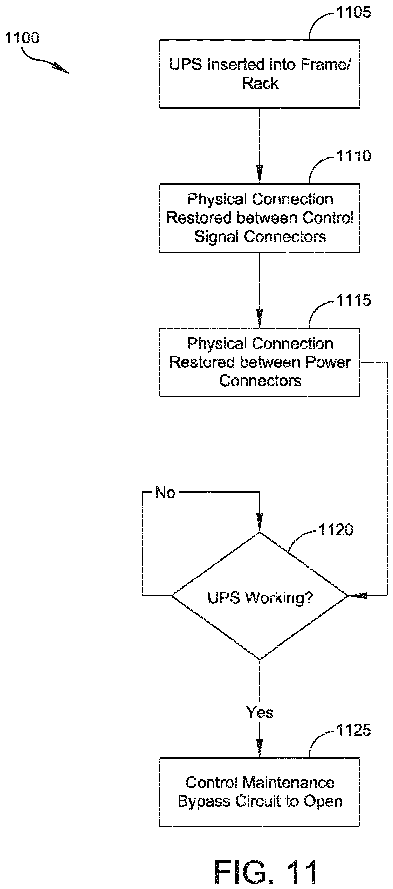

After the maintenance bypass switch 405 closes during act 915, input power is rerouted through the maintenance bypass branch 410 and out of the power output line 215b, bypassing the UPS 205. At act 920, the UPS power connectors 225a, 225b become disconnected from corresponding maintenance bypass unit power connectors 235a, 235b causing the UPS 205 to lose its physical connection to the maintenance bypass unit 220. Since power was already diverted through the maintenance bypass branch 410 during act 915, the possibility of any buildup of a voltage potential, and any arcing, between the UPS power connectors 225a, 225b and the corresponding bypass unit power connectors 235a, 235b as they are separated is reduced. Further, since the power through the input 215a is shunted around the UPS 205 through the bypass branch 410 and out through the output 215b, the UPS 205 is able to be electrically decoupled from the system 200 without decoupling any loads that may be attached to the output 215b. At act 925, the UPS 205 is completely removed from its frame 210 and may be subsequently replaced, serviced, updated, etc. while it is disconnected from the system 200. Methods associated with inserting a new or repaired UPS 205 back into the system 200 are shown and described in FIG. 11.

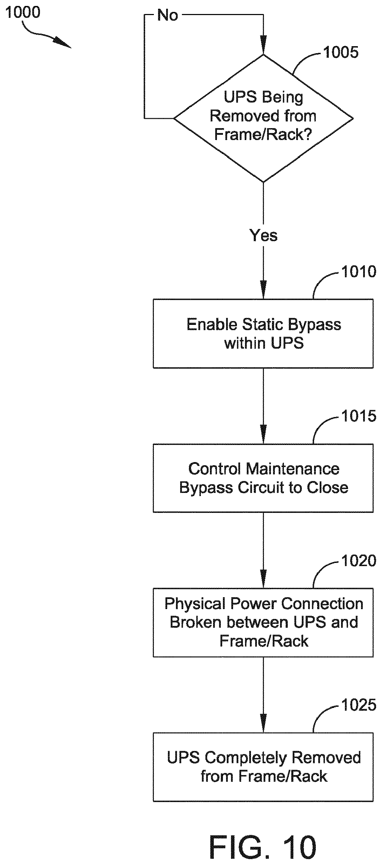

FIG. 10 is a flowchart showing another embodiment of a method 1000 of removing the UPS 205 from its slot 810 within the rack 800 that includes the rack-mountable UPS system 200 of the present disclosure. Acts 1015, 1020, and 1025 of the method 1000 are similar to the respective acts 915, 920, and 925 in the method 900 shown in FIG. 9. At act 1005, the UPS controller 120 actively monitors for a change in the signal status along the control line 610 to determine that the UPS 205 is being removed from the frame 210. The controller 120 may be programmed to monitor the signal status continuously, at predetermined intervals, or in accordance with another schedule.

As the UPS 205 is being removed from its frame 210, the one or more pairs of control signal connectors 230a, 230b, 240a, and 240b become disconnected causing a change in the signal along control lines 605 and 610. In response to the change in the signal, acts 1010 or 1015 are performed in response, and can be executed in either order or simultaneously. At act 1010, the UPS controller 120 closes the static bypass switch 145 and enters the static bypass mode as discussed above. At act 1015, one or more pairs of control signal connectors 230a, 240a become disconnected causing the maintenance bypass 405 switch to close in response.

The method then continues to execute acts 1020 and 1025, which are identical to the respective acts 920 and 925 shown in FIG. 9. By activating the static bypass mode during act 1010 and the maintenance bypass mode during act 1015 before the power connectors physically disconnect during act 1020, the likelihood and severity of arcing between the power connectors or other potential sources of electrostatic damage to the UPS may be further reduced.

FIG. 11 is a flowchart showing an embodiment of a method 1100 of inserting a UPS 205 into the slot 810 within the rack 800. For example, a user 815 may need to replace a broken or outdated UPS 205 that was previously removed from the slot 810 pursuant to one of the methods shown in FIGS. 9-10. Alternatively, a user 815 may need to reinstall a repaired UPS 205 that was similarly removed from the slot 810 as discussed with respect to FIGS. 9-10. At act 1105, the user 815 begins inserting the UPS unit 205 into the frame 210. At act 1110, the UPS power connectors 225a, 225b contact and become electrically connected to the corresponding bypass unit power connectors 235a, 235b. At act 1115, as the UPS 205 is pushed into a fully engaged position within the frame 210, the UPS control signal connectors 230a, 230b mate with and become electrically connected to the corresponding bypass unit control signal connectors 240a, 240b.

Next, at act 1120, the UPS controller 120 determines whether the UPS 205 is in satisfactory working condition. If the UPS controller 120 determines that the UPS 205 is not in satisfactory working condition, the UPS controller 120 does not send any control signals over signal line 610, keeping the maintenance bypass switch 405 closed such that power continues through the maintenance bypass branch 410 and does not enter the UPS 205. The UPS controller 120 may be configured to repeat act 1120 and monitor the working condition of the UPS continuously, at predetermined intervals, or in accordance with another schedule.

If the UPS controller 120 determines that the UPS 205 is in satisfactory working condition, the method 1100 proceeds to act 1125. At act 1125, the UPS controller 120 sends a signal over signal line 610, through the signal line 605, causing the maintenance bypass switch 405 to open and allowing power to enter the UPS 205 via the power connectors 225a, 225b, 235a, and 235b. In certain embodiments, the UPS 205 may be configured to have entered the static bypass mode by default or upon being disengaged from the maintenance bypass unit 220 previously. In some of these embodiments, at act 1125 the UPS controller 120 will also control the static bypass switch 145 to open in response to determining that immediate backup power or battery charging is required. Alternatively, the UPS 205 may be configured to immediately enter the static bypass mode upon first engaging the maintenance bypass unit 220 or other control circuitry.

In various embodiments described herein, the rack-mounting UPS system 200 may be compatible with power devices other than the UPS 205 described above. The power devices may or may not include a UPS and may perform additional functions in addition to those typically provided by a UPS. In other embodiments, the racks 800 being used to house the UPS devices 205 may also be capable of receiving other rack-mountable devices that do not perform UPS functions, for example, servers, battery packs, or other rack-mountable electronic equipment known to those skilled in the art. Throughout this disclosure, rack-mountable devices such as the UPS 205 are depicted as having a roughly rectangular cross-sectional shape and the racks 800 are depicted as having a vertical arrangement of slots 810. However, those skilled in the art will appreciate that rack-mountable devices may possess any shape suitable for performing their desired functions and the slots 810 within a rack 800 may be arranged in any orientation suitable for containing the associated rack-mountable devices.

In various embodiments described herein, reference is made to rack-mountable UPS devices configured to be inserted into a frame designed to be positioned in a slot of a rack. Those having skill in the art will appreciate, given the benefit of this disclosure, that a frame may be located partially or fully inside or outside of the corresponding slot, and may include one or more telescopic pieces designed to permit all or part of the frame to be moved between interior and exterior portions of the slot. In various embodiments, a UPS in accordance with at least one embodiment may instead include an exterior chassis designed to mate with and engage one or more interior portions of a slot without using an intermediate frame.

In various embodiments herein, the UPS bypass system 200 of the present disclosure is described as having two sets of power signal connectors and two sets of control signal connectors, each set being disposed on one of the UPS unit 205 and the bypass unit 220. In certain embodiments, the system 200 may be designed to instead include greater or fewer sets of power signal connectors or control signal connectors. For example, the system may be configured to operate with two sets of power connectors and a single set of control signal connectors.

In various embodiments herein, the system 200 is described as having a single maintenance bypass switch 405 and a single maintenance bypass branch 410 plus any corresponding control circuitry for controlling the switch 405. In certain embodiments, the system 200 may include additional bypass switches 405 or bypass branches 410 to provide additional or redundant bypass functionality. For example, the bypass unit 220 may include a second bypass branch 410 and bypass switch 405 arranged in parallel to the first bypass branch 405 and bypass switch 405 for providing a redundant bypass path in case the primary path malfunctions. In another example, the bypass branch 410 may include multiple bypass switches 405 arranged in series so as to prevent an accidental closing of a single switch from engaging the bypass mode.

It is to be appreciated that examples of the methods and apparatuses discussed herein are not limited in application to the details of construction and the arrangement of components set forth in the following description or illustrated in the accompanying drawings. The methods and apparatuses are capable of implementation in other examples and of being practiced or of being carried out in various ways. Examples of specific implementations are provided herein for illustrative purposes only and are not intended to be limiting. Also, the phraseology and terminology used herein is for the purpose of description and should not be regarded as limiting. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms. Any references to front and back, left and right, top and bottom, upper and lower, and vertical and horizontal are intended for convenience of description, not to limit the present systems and methods or their components to any one positional or spatial orientation.

Having described above several aspects of at least one implementation, it is to be appreciated various alterations, modifications, and improvements will readily occur to those skilled in the art. Such alterations, modifications, and improvements are intended to be part of this disclosure and are intended to be within the scope of the description. Accordingly, the foregoing description and drawings are by way of example only, and the scope of the disclosure should be determined from proper construction of the appended claims, and their equivalents.

## Claims

1. An uninterruptible power supply (UPS) system comprising:
a UPS unit having a first UPS connector and a second UPS connector;
a frame configured to removably engage and receive the UPS unit; and
a bypass unit disposed within the frame including:
an input to receive input power;
an output to provide output power;
a bypass branch configured to selectively couple the input to the output, the bypass branch including a bypass switch configured to switch between an open state and a closed state, in the open state the bypass switch being configured to prevent current through the bypass branch, and in the closed state the bypass switch being configured to allow current through the bypass branch;
a first power connector disposed on the bypass unit, the first power connector coupled to the input and configured to couple to the first UPS connector responsive to the UPS unit being received by the frame; and
a second power connector disposed on the bypass unit, the second power connector coupled to the power output and configured to electrically couple to the second UPS connector responsive to the UPS unit being received by the frame.

2. The uninterruptible power supply system of claim 1 wherein the first and second power connectors and the first and second UPS connectors are configured to couple the bypass unit to the UPS unit responsive to the UPS unit being inserted into the frame beyond a first position of the frame located between a front portion of the frame and the bypass unit.

3. The uninterruptible power supply system of claim 2 further comprising a bypass control signal connector disposed on the bypass unit, the bypass control signal connector configured to electrically couple to the UPS unit responsive to the UPS unit being received by the frame.

4. The uninterruptible power supply system of claim 3 wherein the bypass control signal connector is configured to electrically couple to the UPS unit responsive to the UPS unit being inserted into the frame beyond a second position of the frame located closer to the bypass unit than the first position.

5. The uninterruptible power supply system of claim 4 wherein the bypass switch is configured to receive a first bypass signal from the UPS unit through the bypass control signal connector, the first bypass signal being configured to switch the bypass switch from the closed state to the open state.

6. The uninterruptible power supply system of claim 5 wherein the bypass switch includes a normally closed relay.

7. The uninterruptible power supply system of claim 5 wherein the bypass switch is configured to receive a second bypass signal from a controller disposed within the frame, the second bypass signal being configured to control the bypass switch to the closed state.

8. The uninterruptible power supply system of claim 5 wherein the UPS is configured to transmit the first bypass signal responsive to determining that the UPS is operating in satisfactory condition.

9. The uninterruptible power supply system of claim 6 wherein the bypass switch is configured to switch to the closed position responsive to the UPS being removed from the frame past the second position.

10. The uninterruptible power supply system of claim 9 wherein the UPS is configured to operate in a static bypass mode responsive to the UPS being removed from the frame past the second position.

11. A method for controlling power to an uninterruptible power supply (UPS) system having a frame configured to receive a UPS and a bypass unit positioned within the frame, the bypass unit including a first input to receive input power from a power source, a first output to provide output power to a load, a second output to provide power to the UPS, a second input to receive power from the UPS, and a bypass branch having a bypass switch coupled between the first input and the first output, the method comprising:
controlling the bypass switch to switch from an open state to a closed state responsive to the UPS being disengaged from the bypass unit and removed from the frame, the open state being configured to prevent current through the bypass branch and the closed state being configured to allow current through the bypass branch to allow the bypass unit to operate in a bypass mode of operation; and
controlling the bypass switch to switch from the closed state to the open state responsive to the UPS being received by the frame and engaged with the bypass unit.

12. The method of claim 11 wherein controlling the bypass switch to switch from the open state to the closed state responsive to the UPS being removed from the frame is further responsive to the UPS being removed from the frame beyond a first position in the frame between a front portion of the frame and the bypass unit.

13. The method of claim 12 wherein controlling the bypass switch from the closed state to the open state responsive to the UPS being received by the frame is further responsive to the UPS being inserted into the frame beyond the first position.

14. The method of claim 13 further comprising controlling the UPS to enter a static bypass mode responsive to the UPS being inserted into the frame beyond the first position.

15. The method of claim 14 further comprising:
determining whether the UPS is operating in a satisfactory condition; and
disabling the static bypass mode responsive to determining that the UPS is operating in the satisfactory condition.
